# EUROPÄISCHE PATENTSCHRIFT

(11) **EP 1 580 816 B1**
(45) Veröffentlichungstag und Bekanntmachung des Hinweises auf die Patenterteilung: **29.05.2013**
(21) Anmeldenummer: 05006058.1
(22) Anmeldetag: 19.03.2005
(51) Int. Cl.: G02B 1/11, H01L 31/0216, G09F 13/16

(54) **Verfahren zur Herstellung eines Elements, umfassend ein reflektierendes Substrat und eine Antireflexschicht**
Method of manufacturing an element having a reflective substrate and an anti-reflective coating
Procédé de fabrication d'un élément ayant un substrat réflecteur et une couche anti-réflective

(30) Priorität: 27.03.2004 DE 102004015177
(43) Veröffentlichungstag der Anmeldung: 28.09.2005
(73) Patentinhaber: Karlsruher Institut für Technologie, 76131 Karlsruhe (DE)
(72) Erfinder: Walheim, Stefan, Dr., 76356 Weingarten (DE); Hedderich, Regine, Dr., 76356 Weingarten (DE); Schimmel, Thomas, Prof. Dr., 76131 Karlsruhe (DE)

(56) Entgegenhaltungen:
- DE-A1- 19 526 733
- US-A1- 2003 157 248
- US-A1- 2003 215 626

## Beschreibung

Die Erfindung betrifft ein Verfahren zur Herstellung eines Elements, umfassend ein reflektierendes Substrat und eine Antireflexschicht, die Poren aufweist, deren Dimensionen unterhalb der Wellenlänge des sichtbaren Lichts oder benachbarter Spektralbereiche liegen.

Die DE 195 26 733 A1 offenbart eine Solarzelle, die eine mineralische Antireflexschicht mit in Form eines Musters ausgebildeten Bereichen aufweist, in denen die Antireflexschicht ganz oder teilweise entfernt ist. Zur Herstellung des Musters wird die Solarzelle mit einer Antireflexschicht versehen, auf Bereichen der Antireflexschicht eine Ätzmaske in Form eines Musters erzeugt und die Antireflexschicht in den nicht von der Ätzmaske bedeckten Bereichen durch Ätzen ganz oder teilweise entfernt. Nachteilig hieran ist, dass dieses Verfahren mehrere Prozessschritte für Maskenherstellung, Ätzen und das anschließende Waschen erfordert und nur auf Substraten eingesetzt werden kann, die diesen Prozessschritten standhalten.

Die US 2003/0215626 A1 offenbart eine nanoporöse Beschichtung, die aus einem Polyelektrolyt mittels eines wässrigen Verfahrens hergestellt wird.

Die US 2003/0157248 A1 offenbart ein Verfahren zur Herstellung eines mesoporösen Materials, bei dem ein Templat von einem Precursor durchdrungen wird und mit diesem zu einer Ablagerung reagiert. Anschließend hieran wird das Templatmaterial entfernt, wodurch das mesoporöse Material erhalten wird.

Ausgehend hiervon ist es die Aufgabe der vorliegenden Erfindung, ein Verfahren zur Herstellung eines Elements, umfassend ein reflektierendes Substrat und eine Antireflexschicht vorzuschlagen, das die vorher genannten Nachteile und Einschränkungen nicht aufweist.

Diese Aufgabe wird durch die Verfahrensschritte des Anspruchs 1 gelöst. Die Unteransprüche beschreiben vorteilhafte Ausgestaltungen der Erfindung.

Ein mit dem erfindungsgemäßen Verfahren hergestelltes Element umfasst eine Antireflexschicht, die Bereiche in Form eines Musters aufweist, in denen der Volumenanteil der Poren in der Antireflexschicht, verglichen mit der jeweils zu diesen Bereichen unmittelbar benachbarten Antireflexschicht, um mindestens 10 %, bevorzugt um mindestens 20 %, besonders bevorzugt um mindestens 30 %, d. h. auch um bis zu 50-60 % geringer ist. Im Extremfall wird die Antireflexschicht völlig zusammengedrückt, so dass diese praktisch keine Poren mehr enthält. Die Antireflexschicht muss hierzu Poren enthalten, deren Dimensionen wie z. B. der mittlere Durchmesser unterhalb der Wellenlänge des sichtbaren Lichts oder benachbarter Spektralbereiche, insbesondere zwischen der Hälfte und einem Zwanzigstel der Wellenlänge, liegen.

Diese Materialien besitzen einen effektiven mittleren Brechungsindex, der durch das Mittel über den Brechungsindex des Materials und der in den Poren enthaltenen Luft gegeben ist, über die ganze Dicke der Antireflexschicht oder weisen Variationen im Porenanteil wie beispielsweise einen Gradienten über die Dicke der Antireflexschicht auf. Durch Variation des Volumenanteils der Poren lässt sich somit der Brechungsindex der Antireflexschicht ändern. Die vorliegende Erfindung macht davon Gebrauch, dass sich mit verringertem Volumenanteil der Poren die Reflektivität der Antireflexschicht im sichtbaren Bereich des elektromagnetischen Spektrums oder benachbarter Spektralbereiche und insbesondere aufgrund der Interferenz auch die Farbe der Antireflexschicht ändern.

Das Material, aus dem die Antireflexschicht gebildet ist, umfasst vorzugsweise Polymere oder poröse Metalloxidschichten, die nach einem der bekannten Verfahren hergestellt werden. Beispielhaft erwähnt seien die Sol-Gel-Verfahrenstechnik zum Beispiel zur Herstellung von porösen Metalloxidschichten nach der DE 198 28 231 A1 oder von organisch modifizierten porösen Keramikschichten, die Phasentrennung von Polymermischungen, die Polymere wie Polystyrol, Polymethylmethacrylat, Polymethacrylat, Polyacrylat, Polyvinylpyridin, Polyvinylchlorid oder fluorierte Polymere gemäß der DE 198 29 172 A1 enthalten, oder eine Kombination aus Polymerphasenentmischung und Sol-Gel-Verfahren.

Ein mit dem erfindungsgemäßen Verfahren hergestelltes Element umfasst weiterhin ein Substrat, das bei Bestrahlung mit sichtbarem Licht oder elektromagnetischer Strahlung aus hierzu benachbarten Spektralbereichen zumindest unter einigen Winkeln (teil-)reflektierend wirkt. In einer bevorzugten Ausführungsform besitzt dieses Substrat transparente Eigenschaften, wie sie beispielsweise Glas oder Kunststoffe wie Polymethylmethacrylat, Polycarbonat oder Polyester aufweisen. Diese Transparenz ermöglicht das Aufbringen von Strukturen (Mustern) auf reflektierende Oberflächen von transparenten Objekten (z. B. Glas- oder transparente Kunststoffscheiben) ohne Transmissionsverlust bei voller Erhaltung der Transparenz. Ein Betrachter kann durch ein derartiges Muster hindurch sehen, das nur unter bestimmten Winkeln, abhängig vom jeweiligen Beleuchtungswinkel, vom Beobachtungswinkel und vom Winkelbereich, den die Lichtquelle einnimmt, überhaupt wahrnehmbar ist. Im übertragenen Sinne kann hier von einem *Glas (Kunststoff) mit Wasserzeichen* gesprochen werden.

In einer alternativen Ausgestaltung ist das reflektierende Substrat, auf dem die Antireflexschicht aufgebracht ist, eine undurchsichtige Oberfläche eines Gegenstands, die auch lackiert sein kann. Auch hier ist eine Struktur (Muster) auf der Oberfläche aufgebracht, die nur unter den bestimmten, oben genannten Winkeln wahrgenommen werden kann. Unter anderen Winkeln erscheint die Oberfläche im Wesentlichen unmodifiziert. Im übertragenen Sinne kann hier von einer *Matten Oberfläche mit Wasserzeichen* oder, falls das hergestellte Muster denjenigen Bereich der Antireflexschicht darstellt, worin der Volumenanteil unverändert bleibt (*inverses* Muster), von einer *Glänzenden Fläche mit Mattem Wasserzeichen* gesprochen werden.

In einer weiteren Ausgestaltung weisen die Bereiche mit verringertem Volumenanteil der Antireflexschicht eine periodische Struktur auf. In diesem Falle, insbesondere dann, wenn die Strukturen laterale Dimensionen im Bereich von 0,1 bis 100 Mikrometern aufweisen, bilden die regelmäßigen (z. B. periodische) Anteile der Strukturen (Muster) ein optisch diffraktives Element wie zum Beispiel eine diffraktive Linse oder ein Hologramm.

Zur erfindungsgemäßen Herstellung eines Elements wird in Verfahrensschritt a) ein reflektierendes Substrat, das undurchsichtig oder transparent sein kann, bereitgestellt, auf das auf mindestens einer Seite eine Antireflexschicht aufgebracht ist, die Poren aufweist, deren Dimensionen unterhalb der Wellenlänge des sichtbaren Lichts oder angrenzender Spektralbereiche, insbesondere zwischen der Hälfte und einem Zwanzigstel der Wellenlänge, liegen.

Anschließend wird die Antireflexschicht entsprechend Verfahrensschritt b) mit einem strukturierter Stempel beaufschlagt und dadurch gestaucht. Die vorstehenden Strukturen des Stempels drücken diejenigen Bereiche der Antireflexschicht zusammen, mit denen der Stempel in Kontakt kommt. In Folge verringert sich der Volumenanteil der Poren in der Antireflexschicht in diesen Bereichen, verglichen mit der jeweils zu diesen Bereichen benachbarten Antireflexschicht, die nicht in Kontakt mit dem Stempel gelangte. An denjenigen Stellen, an denen der Stempel Kontakt mit der Antireflexschicht hatte, wird deren Brechungsindex verändert, wodurch sich ihre antireflektierende Eigenschaft so ändert, dass eine Struktur (Muster) in der Antireflexschicht, im Falle von sichtbarem Licht mit bloßem Auge, erkennbar wird. Die gestempelte bzw. geprägte Struktur ist fast ausschließlich in Reflexion zu sehen.

Die Erfindung basiert im Wesentlichen darauf, dass poröse Antireflexschichten weich sind gegenüber dem äußerem Druck, wie ihn beispielsweise der Stempel ausübt, da es zur Verringerung des Volumenanteils der Poren genügt, einen Teil der in den Poren enthaltenen Luft heraus zu drücken und kein Material über Strecken, die länger sind als die Dicke der Antireflexschicht, fließen muss. Der äußere Druck verringert führt in erster Linie zum Kollaps der Poren innerhalb derjenigen Bereiche in der Antireflexschicht, die mit dem Stempels in Kontakt kamen; aufgrund der porösen Struktur wird nur geringfügig Material vom Rand der gestempelten Bereiche zur Seite gedrückt, d.h. verdrängt.

Durch Variation des Anpressdrucks lässt sich fast ein beliebiger Stauchungsgrad erzielen, wodurch der Grad der Reflektivität und damit die optische Sichtbarkeit der Struktur (des Musters) frei gewählt werden kann. Aus Gründen der Sichtbarkeit des Musters sollte jedoch der Volumenanteil der Poren in der Antireflexschicht zwischen den gestempelten und den ungestempelten Bereichen sich um mindestens 10 % unterscheiden, kann aber, wie oben bereits erwähnt, sehr viel größere Werte bis hin zur völligen Zusammenstauchung der Schicht annehmen.

Um einfache, kostengünstige Stempel aus Gummi oder Silikon einsetzen zu können, sollten die zur Anwendung des Stempels erforderlichen Kräfte nicht zu hoch sein. Im Falle, dass die nanoporöse Antireflexschicht Polymere umfasst, führen bereits Anpressdrucke im Bereich zwischen 0,01 und 20 N/cm², bevorzugt zwischen 0,1 und 10 N/cm² zu sehr gut sichtbaren Mustern innerhalb der Antireflexschicht. Dagegen benötigt eine mineralische Antireflexschicht zum Beispiel aus porösem Metalloxid einen Anpressdruck oberhalb von 10 N/cm², für den ein metallischer oder keramischer Stempel erforderlich ist. Ein solcher Stempel kann beispielsweise durch ein periodisches Kraftfeld (z. B. Stoßwelle mit Schall oder Ultraschall) betrieben werden.

Stempel aus Gummi oder Silikon sind für das Einbringen von Mustern in eine poröse Antireflexschicht besonders vorteilhaft, da derartige Stempel lange Standzeiten, hohe Toleranz für Partikelverunreinigungen und niedrige Anforderungen an die Planparallelität von Stempel und Element in sich vereinen.

Aufgrund der geringen zur Anwendung kommenden Drücke, wie sie auch auf dem Gebiet des Mikrokontaktstempelns vorkommen, wird hierdurch auch das Erzeugen (Prägen) von Strukturen im Mikrometerbereich möglich. Diese Möglichkeit eröffnet damit die Herstellung von optisch diffraktiven (teilweise periodischen) Strukturen, wie sie zum Beispiel für Hologramme erforderlich sind.

Schließlich wird in Verfahrensschritt c) der Stempel von der nunmehr fertig strukturierten Antireflexschicht abgenommen und das Element aus Substrat und strukturierter Antireflexschicht entnommen, das dann gegebenenfalls einer weiteren Verarbeitung (z. B. Aufbringen oder Einfügen in einen größeren Gegenstand) zugeführt werden.

Mit dem erfindungsgemäßen Verfahren lässt sich eine poröse Antireflexschicht auf einem reflektierenden Substrat in einem einzigen Arbeitsgang, der zudem unter trockenen Bedingungen bei niedrigem Druck abläuft und daher sehr leicht beherrschbar ist, lateral strukturieren. Zusammen mit dem kostengünstigen Aufbringen von polymeren Antireflexschichten auf das jeweilige Substrat ist das erfindungsgemäße Verfahren sehr kostengünstig und daher für die Massenfertigung geeignet.

Erfindungsgemäße hergestellte Elemente finden überall Verwendung, wo Anzeigen (Displays) zum Einsatz kommen wie zum Beispiel auf Monitoren, Handys, Handhelds oder Navigationsinstrumenten, die als transparentes Substrat dienen. Weitere Einsatzbereiche sind die Optik- oder die Solarindustrie, wo Linsen, Prismen usw. bzw. thermische und photovoltaische Solarzellen geeignete transparente Substrate darstellen. Alle reflektierenden Oberflächen (auch lackierte) wie Instrumententafeln, Zifferblätter, Schaufenster, Schaukästen oder Vitrinen lassen sich erfindungsgemäß entspiegeln und anschließend mit einem Muster versehen.

Als Muster kommen in erster Linie Kennzeichnungen für Produkte oder Sicherheitszwecke (Produkt- oder Sicherheitslabel) in Frage. Weiter dienen erfindungsgemäße Elemente als Träger für jegliche Art von Beschriftungen oder graphischen Darstellungen wie Mustern, Bildern, Logos usw. In allen Fällen können Strukturen (Muster) auf eine undurchsichtige oder transparente Oberfläche aufgebracht werden, ohne dass diese Strukturen die Übersichtlichkeit beispielsweise eines Anzeigefeldes permanent stören, andererseits jedoch dauerhaft verfügbar sind.

Die Erfindung wird im Folgenden anhand eines Ausführungsbeispiels näher erläutert.

Auf einem Glassubstrat wird eine polymere nanoporöse Antireflexschicht gemäß S. Walheim, E. Schaeffer, J. Mlynek und U. Steiner, Nanophase-Separated Polymer Films as High-Performance Antireflection Coatings, Science, Band 283, Seite 520, 1999, aufgebracht. Anschließend wird ein strukturierter Gummi- oder Silikon-Stempel mit einem Druck zwischen 0,01 und 20 N/cm² angedrückt. Nach dem Abheben des Stempels ist das Muster (Struktur) in Reflexion sichtbar.

## Patentansprüche

1. Verfahren zur Herstellung eines Elements, umfassend ein reflektierendes Substrat und eine Antireflexschicht, die Poren aufweist, deren Dimensionen unterhalb der Wellenlänge des sichtbaren Lichts oder benachbarter Spektralbereiche liegen, umfassend die folgenden Verfahrensschritte:
a) Bereitstellen des Elements,
b) Beaufschlagen der Antireflexschicht mit einem Stempel, der vorstehende Strukturen aufweist, wobei die vorstehenden Strukturen des Stempels Bereiche der Antireflexschicht so zusammendrücken, dass sich der Volumenanteil der Poren in diesen Bereichen verringert und hierdurch die Struktur des Stempels auf die Antireflexschicht übertragen wird,
c) Abnehmen des Stempels von der Antireflexschicht und Entnehmen des Elements.

2. Verfahren nach Anspruch 1, **dadurch gekennzeichnet, dass** die poröse Antireflexschicht Polymere umfasst und die vorstehenden Strukturen des Stempels einen Anpressdruck zwischen 0,01 und 20 N/cm² auf diejenigen Bereiche der porösen Antireflexschicht ausüben, in denen sich der Volumenanteil der Poren verringert.

3. Verfahren nach Anspruch 2, **dadurch gekennzeichnet, dass** der Stempel aus Gummi oder Silikon besteht.

4. Verfahren nach einem der Ansprüche 1 bis 3, **dadurch gekennzeichnet, dass** die Strukturen des Stempels periodische Anteile aufweisen sind.

5. Verfahren nach einem der Ansprüche 1 bis 4, **dadurch gekennzeichnet, dass** das Substrat transparent ist.

6. Verfahren nach einem der Ansprüche 1 bis 5, **dadurch gekennzeichnet, dass** die Antireflexschicht ein Polymer umfasst.

7. Verfahren nach einem der Ansprüche 1 bis 5, **dadurch gekennzeichnet, dass** die Antireflexschicht eine poröse Metalloxidschicht umfasst.

## Claims

1. Method for manufacturing an element, comprising a reflective substrate and an antireflective layer which has pores whose dimensions are below the wavelength of visible light or adjacent spectral ranges, comprising the following steps:
a) providing the element,
b) subjecting the antireflective layer to a stamp having projecting structures, wherein the projecting structures of the stamp press together regions of the antireflective layer such that the volume of the pores reduces in these regions and the structure of the stamp is thus transferred to the antireflective layer,
c) taking the stamp away from the antireflective layer and removing the element.

2. Method according to claim 1, **characterised in that** the porous antireflective layer comprises polymers and the projecting structures of the stamp exert a contact pressure between 0.01 and 20 N/cm² to those regions of the porous antireflective layer in which the volume of the pores reduces.

3. Method according to claim 2, **characterised in that** the stamp consists of rubber or silicone.

4. Method according to any one of claims 1 to 3, **characterised in that** the structures of the stamp have periodic portions.

5. Method according to any one of claims 1 to 4, **characterised in that** the substrate is transparent.

6. Method according to any one of claims 1 to 5, **characterised in that** the antireflective layer comprises a polymer.

7. Method according to any one of claims 1 to 5, **characterised in that** the antireflective layer comprises a porous metal oxide layer.

## Revendications

1. Procédé d'obtention d'un élément comportant un substrat réfléchissant et une couche anti-reflets comportant des pores dont les dimensions sont situées au-dessous de la longueur d'onde de la lumière visible ou du domaine spectral voisin, comportant les étapes consistant à :
a) préparer l'élément,
b) obtenir la couche anti-reflets avec un tampon qui comporte des structures saillantes, les structures saillantes du tampon comprimant des zones de la couche anti-reflets de façon à diminuer la proportion volumique des pores dans ces zones et transférer ainsi la structure du tampon sur la couche anti-reflets,
c) enlever le tampon de la couche anti-reflets et extraire l'élément.

2. Procédé conforme à la revendication 1,
**caractérisé en ce que**
la couche anti-reflets poreuse renferme des polymères et les structures saillantes du tampon exercent une contrainte de compression comprise entre 0,01 et 20 N/cm² sur les zones de la couche anti-reflets poreuse dans lesquelles la proportion volumique des pores est diminuée.

3. Procédé conforme à la revendication 2,
**caractérisé en ce que**
le tampon est réalisé en caoutchouc ou en silicone.

4. Procédé conforme à l'une des revendications 1 à 3,
**caractérisé en ce que**
les structures du tampon présentent des parties périodiques.

5. Procédé conforme à l'une des revendications 1 à 4,
**caractérisé en ce que**
le substrat est transparent.

6. Procédé conforme à l'une des revendications 1 à 5,
**caractérisé en ce que**
la couche anti-reflets renferme un polymère.

7. Procédé conforme à l'une des revendications 1 à 5,
**caractérisé en ce que**
la couche anti-reflets comporte une couche d'oxyde métallique poreuse.
